# EUROPEAN PATENT SPECIFICATION

(11) **EP 2 473 654 B1**
(45) Date of publication and mention of the grant of the patent: **30.10.2013**
(21) Application number: 10737059.5
(22) Date of filing: 28.07.2010
(51) Int. Cl.: C25F 7/00, C25D 17/06, H01L 21/00

(54) **METHOD FOR ELECTROCHEMICAL PROCESSING OF NON-FLAT SAMPLES**
VERFAHREN ZUR ELEKTROCHEMISCHEN VERARBEITUNG VON UNEBENEN PROBEN
PROCÉDÉ DE TRAITEMENT ÉLECTROCHIMIQUE D'ÉCHANTILLONS NON PLATS

(30) Priority: 01.09.2009 US 238993 P
(43) Date of publication of application: 11.07.2012
(73) Proprietor: IMEC, 3001 Leuven (BE); Katholieke Universiteit Leuven, 3000 Leuven (BE)
(72) Inventor: MASOLIN, Alex, I-33100 Udine (IT); DROSS, Frédéric, B-1030 Schaarbeek (BE)
(74) Representative: Hertoghe, Kris Angèle Louisa
(86) International application number: PCT/EP2010/060965
(87) International publication number: WO 2011/026696

(56) References cited:
- DE-A1-102006 033 353
- DE-U1-202006 012 842
- US-A- 5 904 820
- US-A1- 2003 121 790
- US-A1- 2004 035 712

## Description

### Field of the invention

This invention relates to methods and systems for electrochemical processing of non-flat samples and/or samples that may change shape during electrochemical processing. More in particular it relates to methods and systems for holding such samples and for maintaining a good electrical contact to such samples during electrochemical processing, e.g. electrochemical etching, plating or cleaning.

### Background of the invention

Nowadays' production of photovoltaic cells mainly relies on silicon. The price of silicon photovoltaic modules is to a large extent driven by the cost of the silicon material. Furthermore, with currently industrially achievable surface recombination velocities, the optimum thickness for achieving the highest efficiency of a crystalline silicon photovoltaic cell is in the range of 50 micrometer. For a thickness below a few tens of micrometer, silicon becomes flexible. Encapsulated in a suitable and flexible material, it can provide a building block for applications requiring lightweight, flexible, high efficiency photovoltaic modules.

When forming thin silicon wafers by wire sawing from an ingot, kerf losses consume half of the ingot and the achievable wafer thickness is limited to 100 micrometer or more. Therefore, other methods for forming thin silicon wafers for the photovoltaic industry are needed.

In US 2007/0249140 a wafering technique is described that enables the production of very thin (e.g. thinner than 100 micrometer) crystalline silicon wafers. This process is also known as the SLIM-Cut (Stress-induced Lift-off Method) process. In an embodiment described in US 2007/0249140, on a thick mother substrate (e.g. silicon substrate) a layer (e.g. a metallic layer) with mismatched thermal expansion coefficient with respect to the mother substrate is provided, e.g. screen printed. The thermal coefficient of expansion of the metallic layer is much higher, e.g. more than a factor of 10 higher, than the thermal coefficient of expansion of silicon. Good bonding between the metallic layer and the silicon mother substrate can for example be achieved by a treatment at high temperature in a belt furnace. Upon cooling to room temperature, the metallic layer and the silicon substrate undergo a thermal contraction, and the mismatch in coefficient of thermal expansion between the metallic layer and the silicon induces a large stress field in the mother substrate. Since the bonding between the metallic layer and the silicon is sufficiently strong to withstand this stress load, the stress builds up inside the silicon material during cooling down. When the stress reaches a threshold value, the system tends to relax by the initiation and the propagation of a crack parallel to the main surface of the mother substrate. After the crack has completely propagated through the mother substrate, a film is detached and the mother substrate can be reused. The film detached is composed of the metallic layer and a thin silicon substrate lifted-off from the mother substrate. The film is still under stress and exhibits therefore some bending. In a next step the metal can (at least partially) be removed, resulting in a (flat) thin silicon film on which e.g. a photovoltaic cell process can be applied.

The film detached from the mother substrate may be a rolled-up stack comprising the thin silicon substrate and at least one layer of stress inducing material, e.g. metallic layer. As described in US 2007/0249140, the at least one layer of stress inducing material may be removed e.g. by chemical etching. By removing the at least one layer of stress inducing material the stress is relieved from the thin substrate and the thin substrate can then become flat and stress-free. For example, in case a stress inducing stack comprising a layer of Ag paste and a layer of Al paste is used, removing the Ag/Al layers after release of a film from the mother substrate may comprise dipping the detached film in a warm HCl solution and in a mixture of HCl and HNO₃. However, when using such a chemical etching process, Ag cannot be recovered easily.

### Summary of the invention

It is an object of embodiments of the present invention to overcome the problem mentioned above. This objective is accomplished by a device and a method according to embodiments of the present invention.

Embodiments of the present invention relate to a method and a system for electrochemical processing of non-flat samples and/or samples that can change shape during processing. A system according to one embodiment comprises a sample holder that provides an electrical contact to the sample during electrochemical processing, wherein the holder allows the sample to change shape during electrochemical processing without interrupting the electrical contact. A system according to embodiments of the present invention can be used for processing fragile samples with a low risk of breakage.

It is an advantage of electrochemical etching that it allows a better control of the etch rate and has the potential of higher etch rates as compared to chemical etching, which may lead to faster processing. In addition, etching solutions may be used that are less aggressive than in case of chemical etching. In case of electrochemical etching, metals such as Ag can be recovered more easily than in case of chemical etching.

Embodiments of the present invention relate to a system comprising a sample holder, the sample holder comprising a grid-shaped carrying element and a fixing element adapted for being pressed against each other, thereby allowing clamping of a sample, e.g. a substantially non-flat sample, in between the fixing element and the carrying element. At least one of the carrying element and the fixing element is electrically conductive and maintains an electrical contact to the sample, enabling electrochemical processing.

It is an advantage of a grid-shaped carrying element that during electrochemical processing it permits a good flow of electrolyte towards the sample and it allows the release of bubbles that may be formed during electrochemical processing.

In case the sample is bent in one direction, the fixing element may be a linear element, such that the contact area between the fixing element and the sample is a linear area. It is an advantage of using a linear fixing element that it allows fixing a sample bent in one direction on the carrying element and that it allows the sample to change shape while being fixed on the carrying element. In case of a sample that is bent in more than one direction, the fixing element may be such that the contact area between the fixing element and the sample is a point or a very small area, e.g. a substantially circular area, wherein the dimensions in one direction of the contact area are less than 10% of the dimensions in that direction of the sample.

The carrying element (grid) may be such that it can be bent in a first direction and in a second direction different from the first direction, wherein bending of the carrying element towards the second direction causes the carrying element to be pushed towards the fixing element. The fixing element can be attached to the carrying element or it can be a separate element.

A system according to embodiments of the present invention can advantageously be used for holding a sample, e.g. a substantially non-flat sample or a sample that can change shape during electrochemical processing, e.g. electrochemical etching, cleaning or plating.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

### Brief description of the drawings

Figure 1 is a schematic drawing of a system according to an embodiment of the present invention showing a holder and a sample during introduction into an electrochemical bath.
Figure 1(a) shows a cross-section along the y-direction; Figure 1(b) shows a cross-section along the x-direction.
Figure 2 is a schematic drawing of a system according to an embodiment of the present invention showing a holder and a sample during electrochemical processing. Figure 2(a) shows a cross-section along the y-direction; Figure 2(b) shows a cross-section along the x-direction.
Figure 3 is a schematic drawing of a system according to an embodiment of the present invention showing a holder and a sample after electrochemical etching. A cross section along the x-direction is shown.
Figure 4 is a schematic drawing of a 'vertical' system according to an alternative embodiment of the present invention showing a holder and a sample during electrochemical processing.
Figure 5 shows a cross section of a grid with two stable positions (Fig. 5(a): first position; Fig. 5(b): second position) that can be used for carrying a sample in embodiments of the present invention.

### Detailed description of certain illustrative embodiments

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes. The dimensions and the relative dimensions do not correspond to actual reductions to practice of the invention. In the different drawings, the same reference signs refer to the same or analogous elements. Any reference signs in the claims shall not be construed as limiting the scope.

Furthermore, the terms first, second, third and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising" should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Furthermore, while some embodiments described herein include some but not other features included in other embodiments, combinations of features of different embodiments are meant to be within the scope of the invention, and form different embodiments, as would be understood by those in the art.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention only being limited by the appended claims.

Certain embodiments of the present invention relate to a method and a system for holding non-flat samples during electrochemical processing (e.g. electrochemical etching, electrochemical plating or electrochemical cleaning), wherein the samples can be substantially non-flat and/or wherein the samples can change shape (e.g. become more flat) during the electrochemical process. In one embodiment, the system allows holding the non-flat samples with a low risk of breakage and it allows providing and maintaining an electrical contact to the samples during the whole electrochemical process. For example, if the sample is initially rolled up, it can unroll during the electrochemical process, e.g. etching process, without losing the electrical contact. In one embodiment, the system allows electrochemical etching or cleaning of fragile samples with a low risk of breakage, for example of samples, for example semiconductor material samples such as silicon samples, with a thickness below 100 µm.

A system according to embodiments of the present invention comprises a sample holder comprising as a carrying element a grid for carrying and mechanically supporting the (substantially) non-flat sample, and a fixing element such as e.g. a wire or a rod to fix the sample on the carrying element e.g. during an electrochemical process, thereby allowing clamping the sample in between the fixing element and the carrying element. At least one of the carrying element and the fixing element is electrically conductive and provides an electrical contact to the sample during electrochemical processing. During electrochemical processing the sample, e.g. non-flat sample, is located and fixed in between the carrying element and the fixing element.

The system is further described for a particular embodiment wherein the carrying element is an electrically conductive element, e.g. a metallic grid, carrying the (substantially) non-flat sample and providing an electrical contact to the sample during electrochemical processing, and wherein the fixing element is electrically non-conductive. However, the invention is not limited thereto.

The invention is further described for the exemplary embodiment wherein the system is used for holding a sample comprising a thin silicon layer (e.g. a silicon layer with a thickness lower than 100 micrometer, e.g. lower than 80 micrometer, e.g. lower than 60 micrometer) and at least one metallic layer, the sample being bent in one direction, and for electrochemically etching the at least one metallic layer from the silicon layer. Such a sample comprising a thin silicon layer and at least one metallic layer may for example result from a SLIM-cut process (as described in US 2007/0249140). Before further processing of such a sample after release from a mother substrate, e.g. for making a photovoltaic cell in the thin silicon layer, the at least one metallic layer needs to be removed at least partially. Certain embodiments of the present invention relate to methods and systems for removing the at least one metallic layer by electrochemical etching. Due to stress in the silicon/metal sample, the sample is initially curled or rolled up, e.g. in a cylindrical shape. During the etching process the stress is released and the sample may change its shape, e.g. from a cylindrical shape to a substantially flat or flat shape or to a cylindrical shape with a larger radius. In one embodiment, a sample holder allows uncurling of the sample during the electrochemical process, e.g. electrochemical etching process. During the electrochemical process an electrical contact to the sample is provided, and it is maintained even when the sample is changing shape, e.g. when it is uncurling.

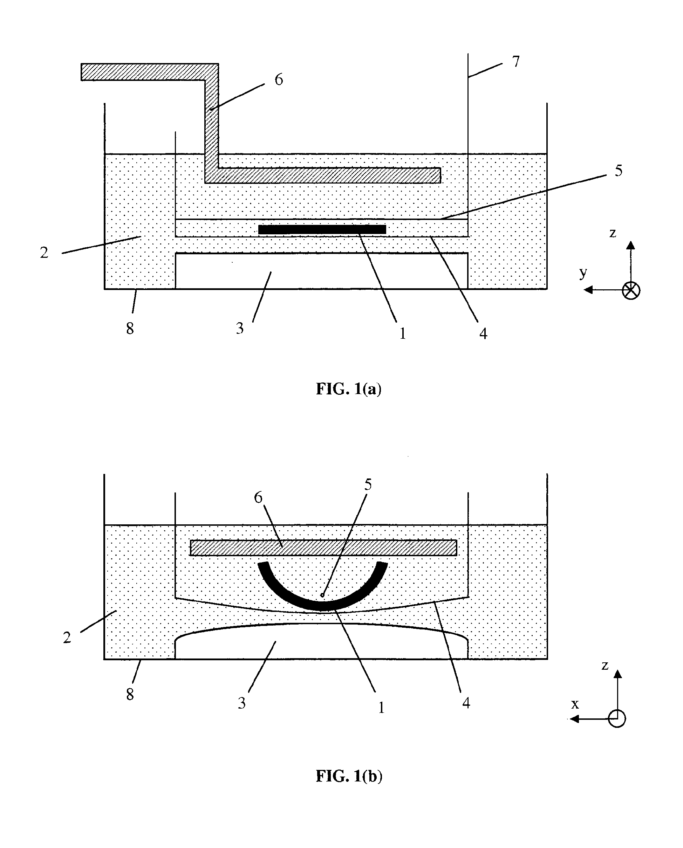

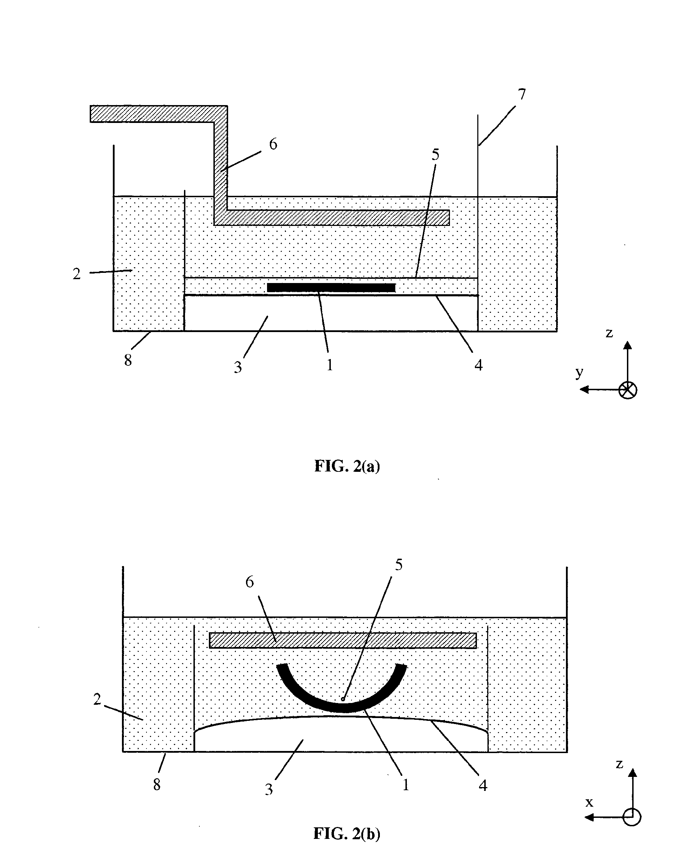

Figure 1 and Figure 2 show schematic drawings illustrating a system according to an embodiment of the present invention, wherein a curled sample 1 comprising a thin silicon layer and at least one metal layer can be etched, i.e. wherein the at least one metal layer can be removed from the sample. Figures 1(a) and 2(a) show a cross section of the system along the y-direction, the y-direction being a direction in which the sample is not bent or curled. Figures 1(b) and 2(b) show a cross section of the system along the x-direction, the x-direction being a direction in which the sample is bent or curled and being substantially orthogonal to the y-direction. An electrochemical etching solution 2, such as e.g. a salt/acid aqueous solution, also called electrolyte, is provided in a container 8, e.g. a beaker made of a material or coated with a material that is not damaged by the electrochemical etching solution, such as for example glass or plastic. In the example shown, at the bottom of the container 8 a platform 3 is provided. This platform 3 can for example have a square shape in a plane parallel to the container bottom and it can for example be bent in one direction. In the embodiment illustrated in Figure 1 and Figure 2, the platform 3 is bent along the x-direction and not along the y-direction. However, other shapes of the platform 3 can be used.

As further illustrated, the platform 3 is used to reverse the bending direction of a grid 4, carrying the sample 1 to be etched. This leads to good fixing of the sample between the grid 4 and a fixing element, e.g wire 5, and thus to good electrical contact to the clamped sample 1. Therefore, the shape of the platform 3 may be compatible with the shape of the grid 4.

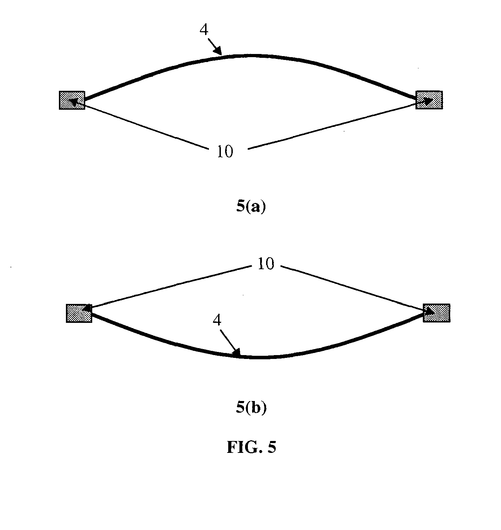

However, in embodiments of the present invention methods other than the use of a platform 3 can be used to reverse the bending direction of a grid 4. For example, as illustrated in Figure 5, a flexible carrying element 4, a grid, can be clamped in a frame 10 of smaller dimensions than the carrying element 4 such that the carrying element 4 can be in two different stable positions, each stable position corresponding to a different bending direction of the carrying element. The carrying element 4 can be bent in a first direction, e.g. as illustrated for example in Figure 5(b), when introducing the sample 1 in the electrochemical processing solution or when removing the sample from the electrochemical processing solution. The carrying element 4 can be bent in a second, different, direction during electrochemical processing, as illustrated for example in Figure 5(a). In such an embodiment there is no need for providing a platform 3 in the container 8. The switching from bending direction, e.g. from the first direction towards the second direction, may be triggered by the carrying element 4 touching the bottom of the container 8. In other embodiments of the present invention a substantially flat carrying element 4 can be used, such that there is no need for reversing a bending direction.

Figure 1 shows a system according to an embodiment of the present invention during introduction of the sample 1 into the container 8 comprising the etching solution 2. Figure 1(a) shows a cross-section along the y-direction; Figure 1(b) shows a cross-section along the x-direction. In the example shown, the sample is introduced in such a way that the direction in which it is bent is aligned with the direction in which the platform 3 is bent (in the example illustrated the x-direction). The sample 1, in the example shown a cylindrically curled sample 1, is placed on a holder comprising an electrically conductive bendable carrying element, grid 4, e.g. an electrically conductive grid such as a metallic grid 4. Other electrically conductive materials may be used for forming the grid 4. In particular embodiments, the curvature of the cylindrical sample has a smaller diameter than the curvature of the carrying element 4. A grid 4 is advantageous as it may improve liquid flows and release of bubbles. The sample 1 is kept in place on the grid 4 by means of a fixing element 5, for example a linear fixing element e.g. a wire 5. Instead of a wire 5, other fixing elements can be used, such as for example a rod or two small fixing elements, one at or close to two opposite extremities of the sample. The fixing element can be a rigid element or a flexible element or can be made of a material that allows some degree of deformation (such as e.g. rubber or foam). The fixing element can be attached to the grid or it can be a separate element. As illustrated in Figure 1(b), the sample 1 is bent in one direction and the wire 5 is oriented in a direction that is substantially equal to a direction in which the sample 1 is not bent. A handler 7 can be attached to the holder, to enable easy handling of the holder comprising the carrying element 4 and the fixing element 5.

Figure 2 shows the system during electrochemical etching. Figure 2(a) shows a cross-section along the y-direction; Figure 2(b) shows a cross-section along the x-direction. The carrying element 4, e.g. bendable grid 4, is pushed to the platform 3 at the bottom of the container 8, such that it follows the shape of the platform 3. In particular embodiments the grid 4, is electrically conductive and provides an electrical contact to the sample 1 to enable electrochemical processing. During electrochemical processing, e.g. etching, the conductive carrying element, grid 4, and the wire 5 are pushed towards one another, thereby clamping the sample 1 and ensuring good electrical contact to the sample. In the etching solution 2 an electrode, e.g. negative electrode 6, is provided. The negative electrode 6 can for example be in the form of a plate or a grid and is made of an electrically conductive material, such as for example stainless steel or any other electrically conductive material that is resistant to the electrochemical process. When the electrode 6 is in the form of a grid, bubbles or gases resulting from the etching process can easily escape.

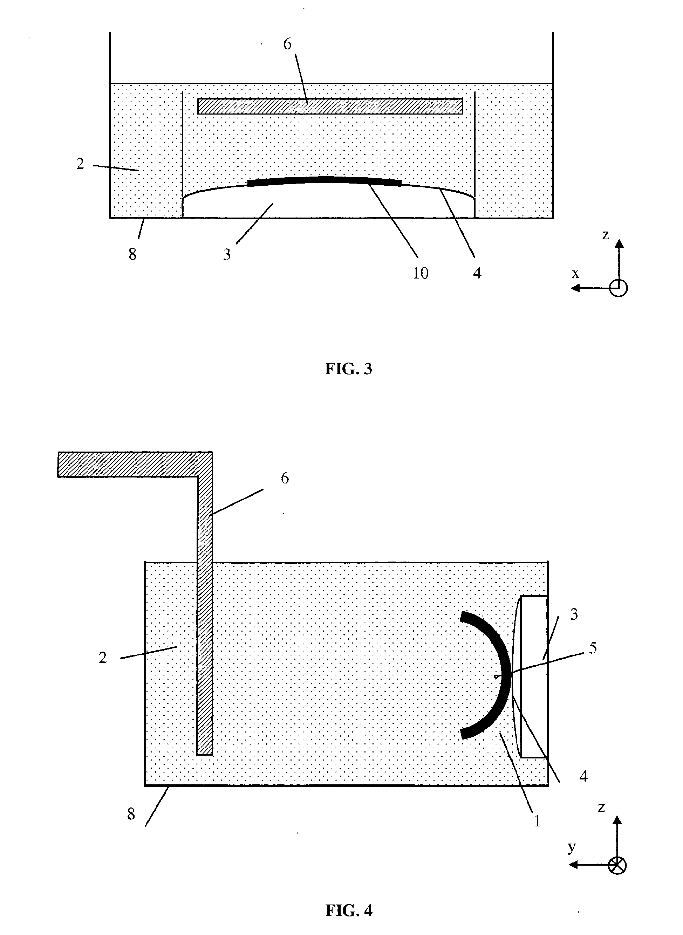

Figure 3 shows the system with the holder and the sample after electrochemical etching. A cross section along the x-direction is shown, i.e. along the direction in which the sample was initially bent. In this particular example, after removing the metallic layer from the sample, the sample is substantially uncurled. It can be removed from the etching bath by means of the holder comprising the carrying element 4 and the handler 7. After electrochemical etching, the etched sample can be fragile, for example it can be a thin silicon layer (e.g. a few tens of micrometers thick).

In embodiments of the present invention the shape of the platform 3 and the carrying element 4 may for example be rectangular, wherein the platform is bent in one direction. However, other shapes are possible, such as a circular shape, en elliptical shape, a polygon shape, etc.

Although in Figures 1 to 3 a horizontal implementation of a system according to embodiments of the present invention is shown, other implementations are possible. For example, to easily remove compounds, e.g. salts, that may be formed during electrochemical processing, a vertical implementation can be used allowing these compounds to fall on the bottom of the beaker e.g. by gravity. In this case a platform 3 would not be provided at the bottom of the container 8 but it could be clamped to the grid holder, as illustrated in Figure 4.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to include any specific characteristics of the features or aspects of the invention with which that terminology is associated.

## Claims

1. A system for electrochemically processing non-flat samples (1) and/or samples that can change shape during the electrochemical processing, the system comprising a sample holder for providing an electrical contact to the sample (1) during electrochemical processing,
wherein the sample holder comprises a grid-shaped carrying element (4) and a fixing element (5) for clamping of the sample (1) in between the fixing element (5) and the carrying element (4), thus providing electrical contact to the sample (1) while allowing the sample (1) to change shape without interrupting the electrical contact.

2. A system according to claim 1, wherein the carrying element (4) is bent in at least a first direction (x).

3. A system according to any of the previous claims, wherein the carrying element (4) is a flexible carrying element clamped in a frame (10) of smaller dimensions than the dimensions of the carrying element (4) such that the carrying element (4) can take on either of two stable positions, each stable position corresponding to a different bending direction of the carrying element (4).

4. A system according to any of claims 2 or 3, furthermore comprising a pre-formed platform (3) for, in use, reversing the bending of the carrying element (4).

5. A system according to any of the previous claims, wherein the fixing element (5) is a linear fixing element.

6. A system according to any of claims 1 to 4, wherein the fixing element (5) is such that, in use, it provides a contact area between the fixing element (5) and a sample in the form of a point or an area with limited dimensions less than 10% of the corresponding dimensions of the sample.

7. A system according to claim 6, wherein the fixing element (5) is such that, in use, the contact area between the fixing element (5) and a sample (1) is a substantially circular contact area.

8. A system according to any of the previous claims, wherein at least one of the fixing element (5) and the carrying element (4) is electrically conductive.

9. A system according to any of the previous claims, furthermore comprising a handler (7) for handling of the sample holder.

10. A method for electrochemically processing of non-flat samples (1) and/or samples that can change shape during processing, the method comprising clamping a sample (1) between a grid-shaped carrying element (4) and a fixing element (5) at at least one point, thus providing an electrical contact to the sample (1), and
electrochemically processing the clamped sample, while allowing the electrochemically processed sample to change shape without interrupting the electrical contact.

11. A method according to claim 10, wherein allowing the electrochemically processed sample, to change shape comprises reversing the bending direction of the carrying element (4) carrying the sample (1).

## Patentansprüche

1. System zum elektrochemischen Verarbeiten unebener Proben (1) und/oder Proben, welche während des elektrochemischen Verarbeitens ihre Form verändern können, umfassend einen Probenhalter zum Bereitstellen eines elektrischen Kontakts zu der Probe (1) während des elektrochemischen Verarbeitens,
wobei der Probenhalter ein gitterförmiges Trägerelement (4) und ein Befestigungselement (5) zum Einklemmen der Probe (1) zwischen dem Befestigungselement (5) und dem Trägerelement (4) umfasst, wobei folglich ein elektrischer Kontakt zu der Probe (1) bereitgestellt wird, während der Probe (1) ermöglicht wird, ihre Form zu verändern, ohne den elektrischen Kontakt zu unterbrechen.

2. System nach Anspruch 1, wobei das Trägerelement (4) in mindestens eine erste Richtung (x) gebogen ist.

3. System nach einem der vorhergehenden Ansprüche, wobei das Trägerelement (4) ein flexibles Trägerelement ist, welches in einem Rahmen (10) von kleineren Abmessungen als den Abmessungen des Trägerelements (4) derartig eingeklemmt ist, dass das Trägerelement (4) eine von zwei stabilen Positionen einnehmen kann, wobei jede stabile Position einer verschiedenen Biegerichtung des Trägerelements (4) entspricht.

4. System nach einem der Ansprüche 2 oder 3, welches weiterhin eine vorgeformte Plattform (3) zum Umkehren der Biegung des Trägerelements (4) beim Betrieb umfasst.

5. System nach einem der vorhergehenden Ansprüche, wobei das Befestigungselement (5) ein lineares Befestigungselement ist.

6. System nach einem der Ansprüche 1 bis 4, wobei das Befestigungselement (5) derartig ist, dass es beim Betrieb eine Kontaktfläche zwischen dem Befestigungselement (5) und einer Probe in der Form eines Punkts oder einer Fläche mit beschränkten Abmessungen von weniger als 10 % der entsprechenden Abmessungen der Probe bereitstellt.

7. System nach Anspruch 6, wobei das Befestigungselement (5) derartig ist, dass die Kontaktfläche zwischen dem Befestigungselement (5) und einer Probe (1) beim Betrieb eine im Wesentlichen kreisförmige Kontaktfläche ist.

8. System nach einem der vorhergehenden Ansprüche, wobei das Befestigungselement (5) und/oder das Trägerelement (4) elektrisch leitfähig ist.

9. System nach einem der vorhergehenden Ansprüche, weiterhin eine Handhabevorrichtung (7) zum Handhaben des Probenhalters umfassend.

10. Verfahren zum elektrochemischen Verarbeiten von unebenen Proben (1) und/oder von Proben, welche ihre Form während des Verarbeitens verändern können, Folgendes umfassend
Einklemmen einer Probe (1) zwischen einem gitterförmigen Trägerelement (4) und einem Befestigungselement (5) an mindestens einem Punkt, wobei folglich ein elektrischer Kontakt zu der Probe (1) bereitgestellt wird, und
elektrochemisches Verarbeiten der eingeklemmten Probe, während der elektrochemisch verarbeiteten Probe ermöglicht wird, ihre Form zu verändern, ohne den elektrischen Kontakt zu unterbrechen.

11. Verfahren nach Anspruch 10, wobei das Ermöglichen der elektrochemisch verarbeiteten Probe, ihre Form zu verändern, ein Umkehren der Biegerichtung des Trägerelements (4) umfasst, welches die Probe (1) trägt.

## Revendications

1. Un système de traitement électrochimique d'échantillons non plats (1) et/ou d'échantillons qui peuvent changer de forme au cours du traitement électrochimique, le système comprenant un porte-échantillon destiné à fournir un contact électrique avec l'échantillon (1) au cours du traitement électrochimique,
où le porte-échantillon comprend un élément support en forme de grille (4) et un élément de fixation (5) destiné à fixer l'échantillon (1) entre l'élément de fixation (5) et l'élément support (4), fournissant ainsi un contact électrique avec l'échantillon (1) tout en permettant à l'échantillon (1) de changer de former sans interrompre le contact électrique.

2. Un système selon la Revendication 1, où l'élément support (4) est courbé dans au moins une première direction (x).

3. Un système selon l'une quelconque des Revendications précédentes, où l'élément support (4) est un élément support flexible fixé dans une armature (10) de dimensions plus petites que les dimensions de l'élément support (4) de sorte que l'élément support (4) puisse adopter l'une ou l'autre de deux positions stables, chaque position stable correspondant à une direction de courbure différente de l'élément support (4).

4. Un système selon l'une quelconque des Revendications 2 ou 3, comprenant en outre une plateforme préformée (3) destinée, en utilisation, à inverser la courbure de l'élément support (4).

5. Un système selon l'une quelconque des Revendications précédentes, où l'élément de fixation (5) est un élément de fixation linéaire.

6. Un système selon l'une quelconque des Revendications 1 à 4, où l'élément de fixation (5) est tel que, en utilisation, il fournit une zone de contact entre l'élément de fixation (5) et un échantillon sous la forme d'un point ou d'une zone avec des dimensions limitées inférieures à 10% des dimensions correspondantes de l'échantillon.

7. Un système selon la Revendication 6, où l'élément de fixation (5) est tel que, en utilisation, le zone de contact entre l'élément de fixation (5) et un échantillon (1) est une zone de contact sensiblement circulaire.

8. Un système selon l'une quelconque des Revendications précédentes, où au moins un élément parmi l'élément de fixation (5) et l'élément support (4) est électriquement conducteur.

9. Un système selon l'une quelconque des Revendications précédentes, comprenant en outre un élément de manipulation (7) permettant de manipuler le porte-échantillon.

10. Un procédé de traitement électrochimique d'échantillons non plats (1) et/ou d'échantillons qui peuvent changer de forme au cours d'un traitement, le procédé comprenant
la fixation d'un échantillon (1) entre un élément support en forme de grille (4) et un élément de fixation (5) au niveau d'au moins un point, fournissant ainsi un contact électrique avec l'échantillon (1), et
le traitement électrochimique de l'élément fixé tout en permettant à l'échantillon traité électrochimiquement de changer de forme sans interrompre le contact électrique.

11. Un procédé selon la Revendication 10, où le fait de permettre à l'échantillon traité électrochimiquement de changer de forme comprend une inversion de la direction de courbure de l'élément support (4) portant l'échantillon (1).
